# EUROPEAN PATENT APPLICATION

(11) **EP 0 949 755 A2**
(43) Date of publication of application: **13.10.1999**
(21) Application number: 99105847.0
(22) Date of filing: 23.03.1999
(51) Int. Cl.: H03F 3/00

(54) **Switched capacitor amplifier with one-clock delay**

(30) Priority: 10.04.1998 JP 9932398
(71) Applicant: Yokogawa Electric Corporation, Tokyo 180-8750 (JP)
(72) Inventor: Segami, Masahiro c/o Yokogawa Electric Corporation, Musashino-shi, Tokyo 180-8750 (JP)
(74) Representative: Henkel, Feiler, Hänzel

(57) **Abstract**

The switched capacitor amplifier comprises first hold capacitors, second hold capacitors, a transconductance amplifier, a first switch circuit for either allowing the first hold capacitors to retain an input voltage, or for outputting the retained input voltage through the transconductance amplifier, and a second switch circuit for either feeding a voltage obtained by reversing the polarity of the voltage retained by the second hold capacitors back to the transconductance amplifier for output as the amplifier's output voltage, or for allowing the voltage retained by the first hold capacitors to be held by the second hold capacitors.

## Description

### [Background of the Invention]

### 1. Field of the Invention

The present invention relates to a switched capacitor amplifier for a circuit integration of reduced scale and capable of operating with reduced power consumption.

### 2. Description of the Prior Art

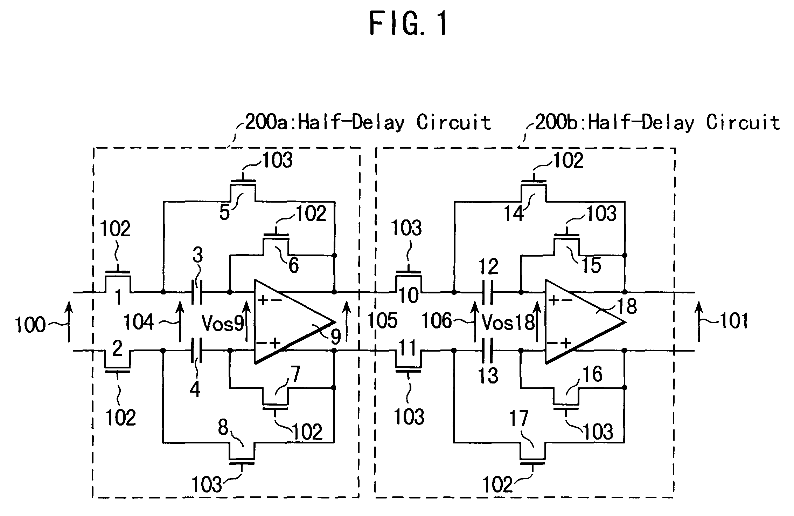

Figure 1 is a circuit diagram showing an example of the conventional switched capacitor amplifiers. In Figure 1, components 1, 2, 5, 6, 7, 8, 10, 11. 14, 15, 16 and 17 are analog switches represented by the symbol for MOS (metal oxide semiconductor) transistors, components 3, 4, 12 and 13 are capacitors, components 9 and 18 are transconductance amplifiers (hereinafter simply referred to as amplifiers), a component 100 is a differential input voltage, a component 101 is a differential output voltage, components 102 and 103 are control signals for controlling analog switches, and components 104, 105 and 106 are voltages at their respective points in the figure. In addition, components 1 to 9 compose a half-delay circuit 200a and components 10 to 18 a half-delay circuit 200b.

The differential input voltage 100 is connected to one end each of the analog switches 1 and 2, the other end of the analog switch 1 is connected to one end each of the capacitor 3 and the analog switch 5, and the other end of the analog switch 2 is connected to one end each of the capacitor 4 and the analog switch 8.

The other end of the capacitor 3 is connected to the non-inverting input terminal of the amplifier 9 and to one end of the analog switch 6, and the other end of the capacitor 4 is connected to the inverting input terminal of the amplifier 9 and to one end of the analog switch 7. In addition, the inverting output terminal of the amplifier 9 is connected to the other end of each of the analog switches 5 and 6 and to one end of the analog switch 10, and the non-inverting output terminal of the amplifier 9 is connected to the other end of each of the analog switches 7 and 8 and to one end of the analog switch 11.

Similarly, the other end of the analog switch 10 is connected to one end each of the capacitor 12 and to the analog switch 14, and the other end of the analog switch 11 is connected to one end each of the capacitor 13 and to the analog switch 17.

The other end of the capacitor 12 is connected to the non-inverting input terminal of the amplifier 18 and to one end of the analog switch 15, and the other end of the capacitor 13 is connected to the inverting input terminal of the amplifier 18 and to one end of the analog switch 16. In addition, the inverting output terminal of the amplifier 18 is connected to the other end of each of the analog switches 14 and 15, and the non-inverting output terminal of the amplifier 18 is connected to the other end of each of the analog switches 16 and 17. In addition, the non-inverting and inverting output terminals of the amplifier 18 provide the differential output voltage 101.

A control signal 102 is connected to the control input terminal of each of the analog switches 1, 2, 6, 7, 14 and 17, and a control signal 103 is connected to the control input terminal of each of the analog switches 5, 8, 10, 11, 15 and 16.

Here, the behavior of the conventional switched capacitor amplifier in Figure 1 is explained using Figures 2, 3 and 4. Figure 2 is a timing diagram showing how the amplifier operates in terms of timing. Figures 3 and 4 show the connection relationship among the circuit components during each timing phase.

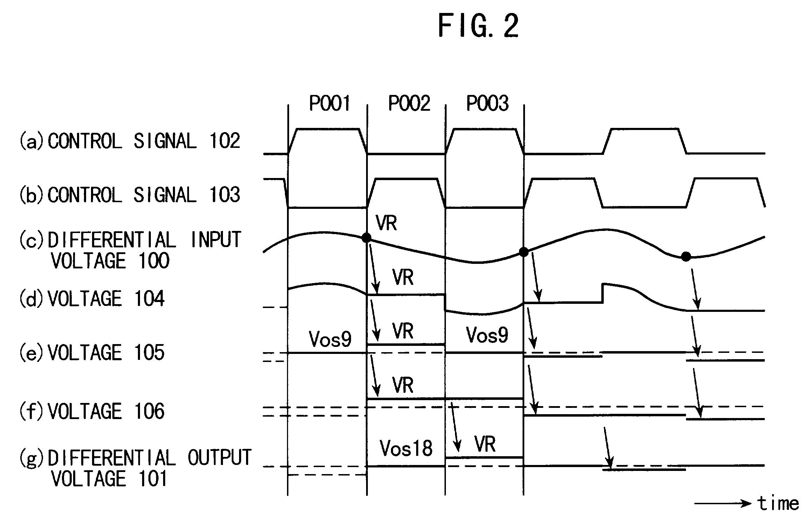

As shown in Figure 2, the control signals 102 and 103 are clock signals having phases which are opposite to each other. During the P001 phase in the figure, the control signal 102 is at a high level and the control signal 103 is at a low level. Hence, the analog switches 1, 2, 6, 7, 14 and 17 are on, and the analog switches 5, 8, 10, 11, 15 and 16 are off.

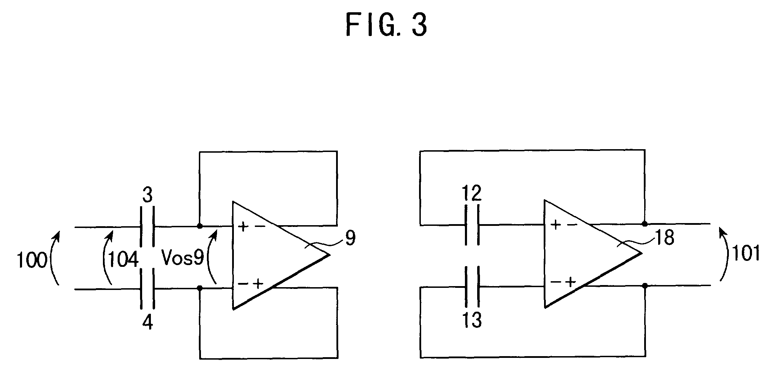

During the P001 phase in Figure 2, the connection relationship between the amplifiers 9 and 18 and the capacitors 3, 4, 12 and 13, which are circuit components, is as shown in Figure 3. That is, the voltage 104 equals the differential input voltage 100 since the voltage 100 is applied to one end each of the capacitors 3 and 4.

The amplifier 9 functions as a voltage follower since its inverting output terminal is fed back to its non-inverting input terminal and its non-inverting output terminal is fed back to its inverting input terminal. Thus, the input terminals of the amplifier 9 serve as artificial grounds and an offset voltage Vos9 develops across these input terminals, as shown in Figure 1.

Accordingly, assuming the differential input voltage 100 is Vin and the voltage 104 is V104, then the differential voltage Vc1 retained by the capacitors 3 and 4 is$\text{Vc1 = V104 - Vos9} \text{= Vin - Vos9}$

During the P002 phase in Figure 2, however, the control signal 102 is at a low level and the control signal 103 is at a high level.

Hence, the analog switches 1, 2, 6, 7, 14 and 17 are off, and the analog switches 5, 8, 10, 11, 15 and 16 are on.

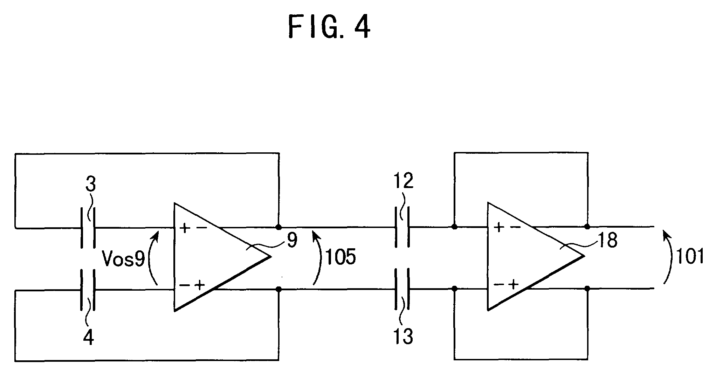

During the P002 phase in Figure 2, the connection relationship between the amplifiers 9 and 18 and the capacitors 3, 4, 12 and 13, which are circuit components, is as shown in Figure 4. In other words, a feedback loop is formed via the capacitors 3 and 4 in the amplifier 9. If the input bias current of the amplifier 9 is zero, the electric charge injected into the capacitors 3 and 4 is not discharged. Hence, the capacitors retain the final value of the differential input voltage 100 when the control signal 102 changes to a low-level state and the control signal 103 changes to a high-level state.

Assuming this final value of the differential input voltage 100 is Vk, the differential voltage Vc2 retained by the capacitors 3 and 4 is$\text{Vc2 = Vk - Vos9}$

If we assume the voltage 105, which is the output voltage of the amplifier 9, equals V105, then V105 is calculated as follows:$\text{V105 = Vc2 + Vos9} \text{= Vk - Vos9 + Vos9} \text{= Vk}$

In other words, the voltage V105, which is the output voltage of the amplifier 9, does not contain the offset voltage Vos9. This means that the offset-voltage component of the output voltage provided by the half-delay circuit 200a is corrected.

Similarly, the voltage 105 is applied as a differential input signal to the half-delay circuit 200b sharing the same structure with the half-delay circuit 200a. Since the half-delay circuit 200b operates with the inverse phase of the half-delay circuit 200a, the final value Vk of the differential output voltage 101 is output during the P003 phase in Figure 2. This means that the final voltage level Vk retained during the P001 phase in Figure 2 is output with a delay of one clock each for the control signals 102 and 103.

As a result, it is possible to correct the offset-voltage component of the retained differential input voltage 100 and output the voltage with a delay of one clock, by connecting the half-delay circuits 200a and 200b in series and driving them with the phases of their control signals reversed to each other.

However, as is understood from the conventional switched capacitor amplifier shown in Figure 1, it is either the amplifier 9 or the amplifier 18 alone that actually processes the differential input voltage 100. In other words, in the condition of Figure 3, the amplifier 18 retains or amplifies the voltage 100, whereas in the condition of Figure 4, the amplifier 9 retains or amplifies the voltage 100. In either condition, the other amplifier runs through a precharging cycle to correct any offset voltage.

This means that only one half of the whole circuitry and the consumed power is used to correct the offset voltage. This leads to the problem that the remaining half of the whole circuitry and the consumed power is wasted. This problem is more serious when the switched capacitor amplifier is operated at higher speeds.

### [Summary of the Invention]

The object of the present invention is to provide a switched capacitor amplifier that has a circuit integration of reduced scale and that consumes less power.

### [Brief Description of the Drawings]

Figure 1 is a circuit diagram representing one example of the conventional switched capacitor amplifier.
Figure 2 is a timing diagram representing the behavior of the circuit of Figure 1.
Figure 3 is a schematic diagram showing the connection relationship among the circuit components during each timing phase.
Figure 4 is another schematic diagram showing the connection relationship among the circuit components during each timing phase.

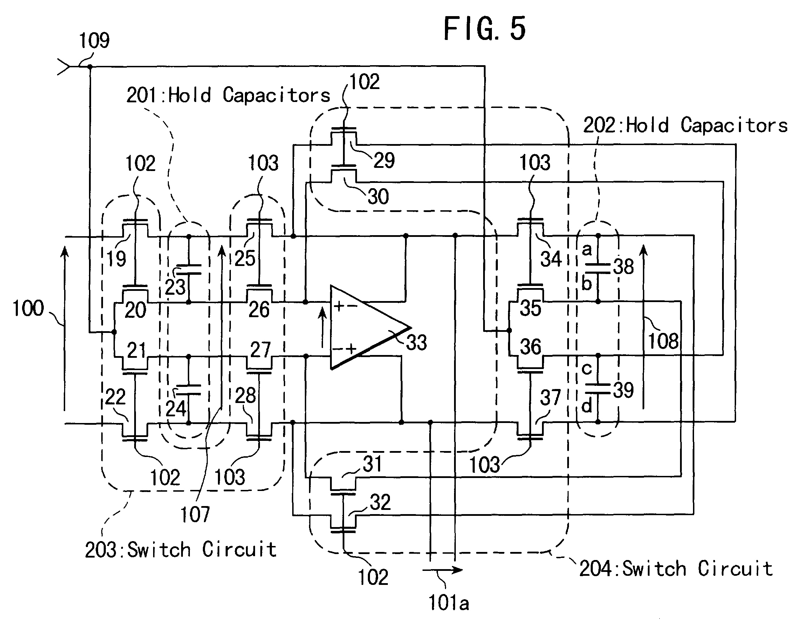

Figure 5 is a circuit diagram showing the first embodiment of the switched capacitor amplifier in accordance with the present invention.

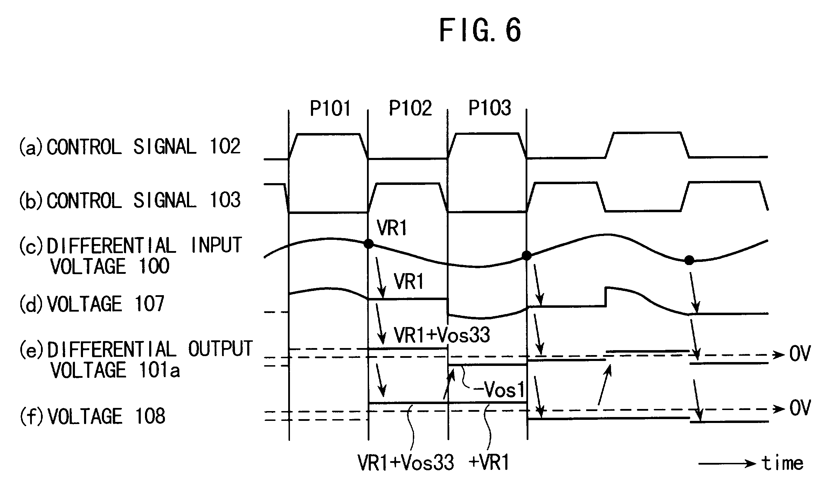

Figure 6 is a timing diagram representing the behavior of the embodiment of Figure 5.

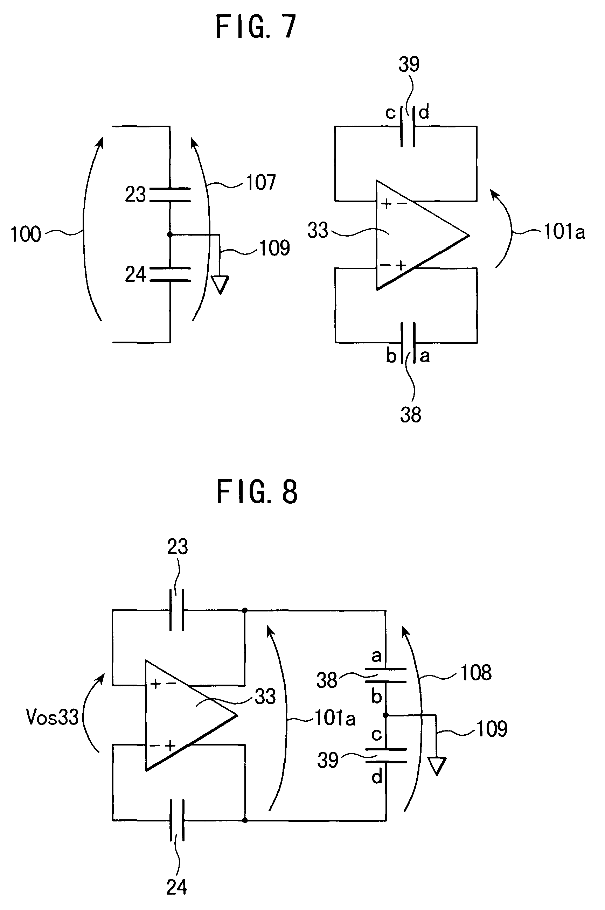

Figure 7 is a schematic diagram showing the connection relationship among the circuit components during each timing phase.
Figure 8 is another schematic diagram showing the connection relationship among the circuit components during each timing phase.

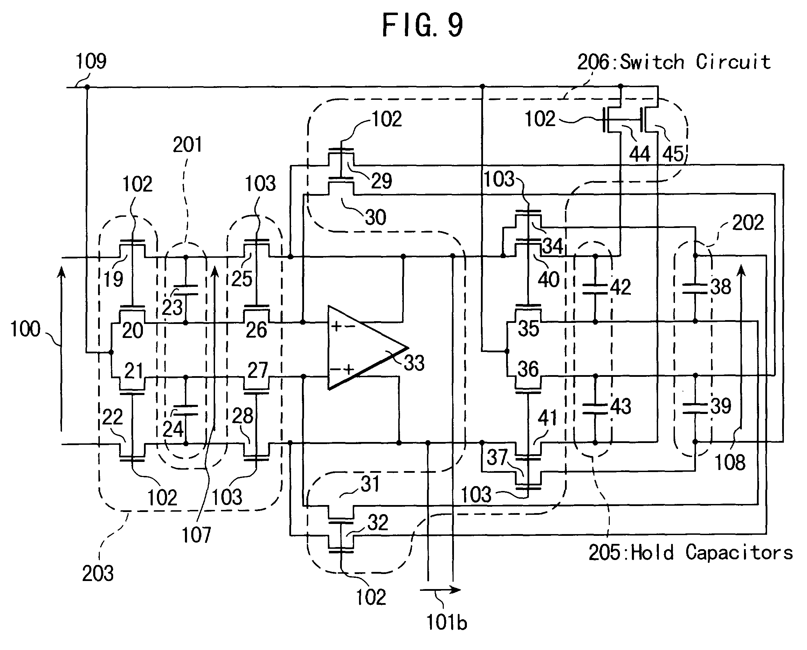

Figure 9 is a circuit diagram showing the second embodiment of the switched capacitor amplifier in accordance with the present invention.

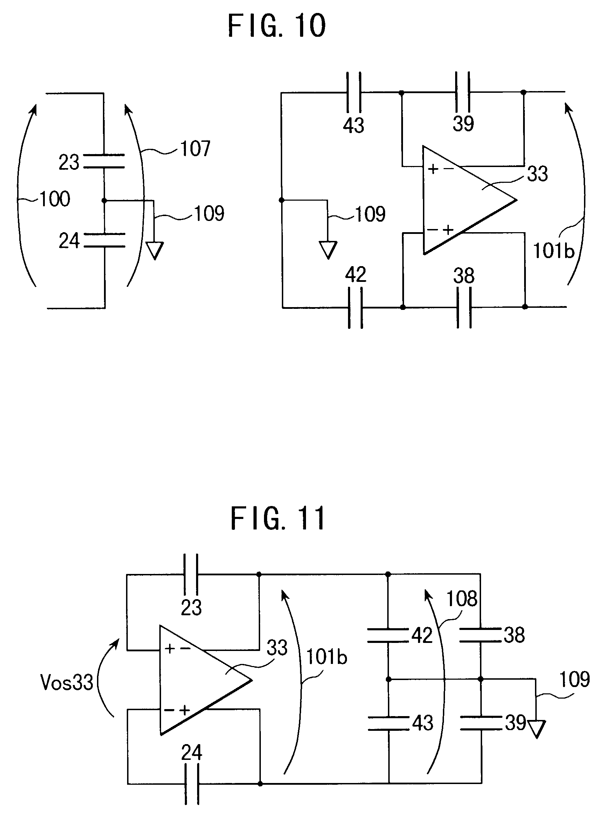

Figure 10 is a schematic diagram showing the connection relationship among the circuit components during each timing phase.
Figure 11 is another schematic diagram showing the connection relationship among the circuit components during each timing phase.

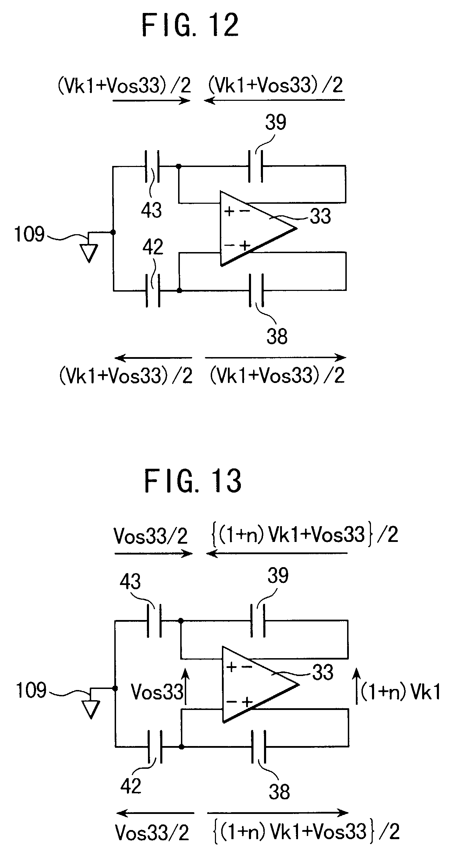

Figure 12 is a schematic diagram showing voltages at the respective circuit components before charge transfer.
Figure 13 is a schematic diagram showing voltages at the respective circuit components after charge transfer.

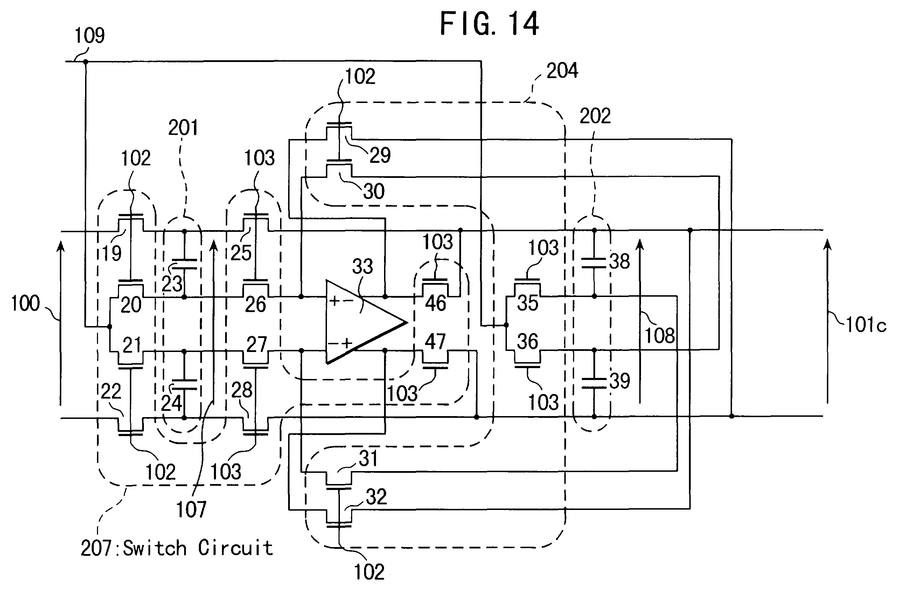

Figure 14 is a circuit diagram showing the third embodiment of the switched capacitor amplifier in accordance with the present invention.

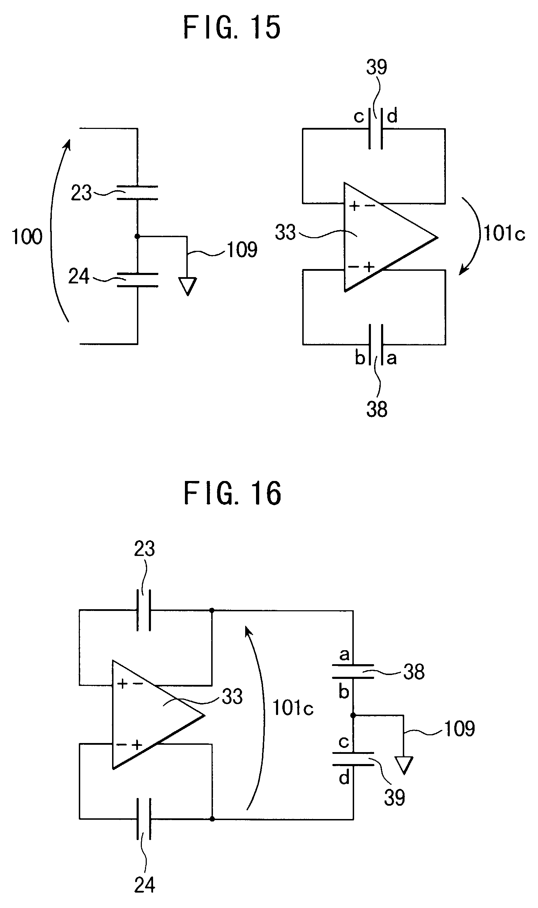

Figure 15 is a schematic diagram showing the connection relationship among the circuit components during each timing phase.
Figure 16 is another schematic diagram showing the connection relationship among the circuit components during each timing phase.

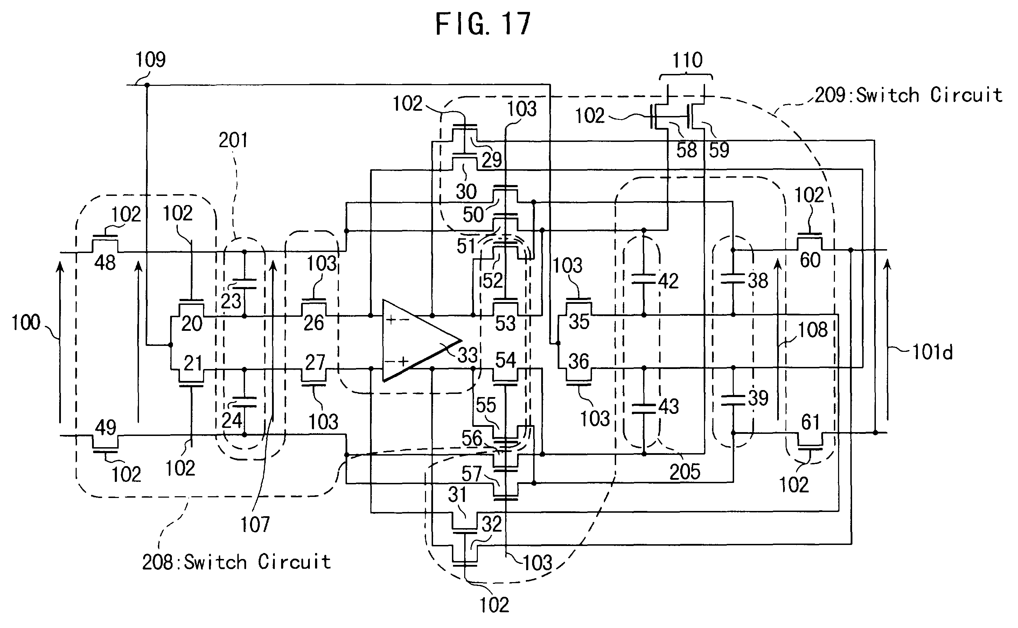

Figure 17 is a circuit diagram showing the fourth embodiment of the switched capacitor amplifier in accordance with the present invention.

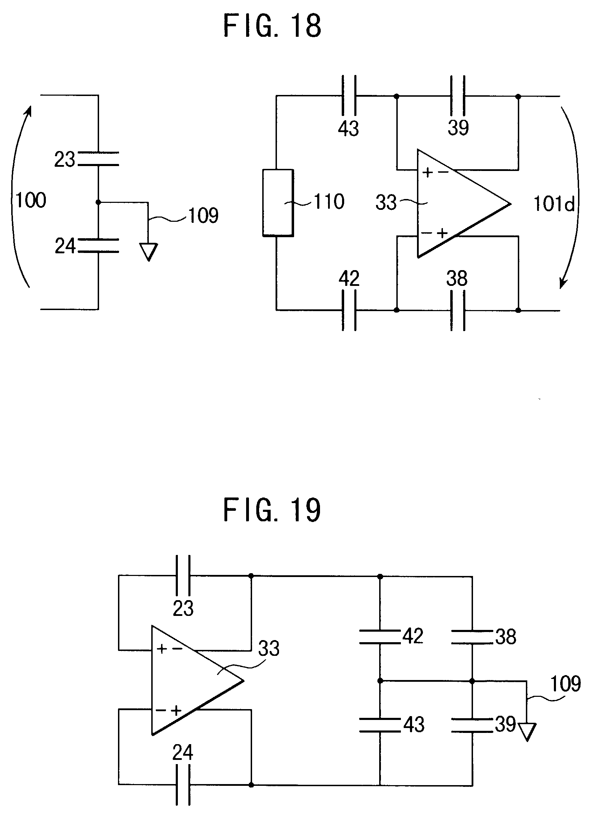

Figure 18 is a schematic diagram showing the connection relationship among the circuit components during each timing phase.
Figure 19 is another schematic diagram showing the connection relationship among the circuit components during each timing phase.

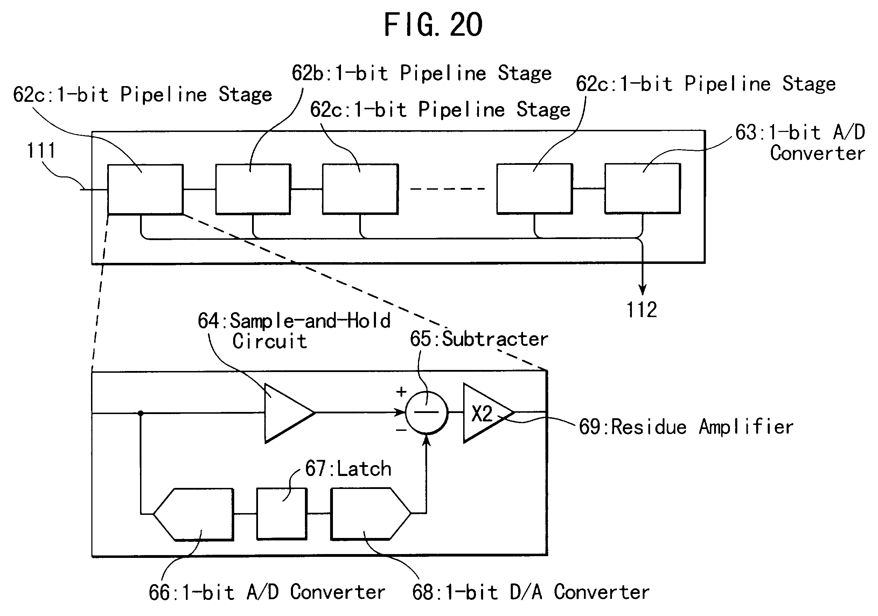

Figure 20 is a block diagram showing one example of the configuration of the switched capacitor amplifier when it is applied to a high-speed pipeline A/D converter.

### [Detailed Description of the Preferred Embodiments]

The present invention is described below in detail using the accompanying drawings.

Figure 5 is a circuit diagram showing the first embodiment of the switched capacitor amplifier in accordance with the present invention.

In Figure 5, the components with reference numbers 100, 102 and 103 are the same as those in Figure 1. Components 19, 20, 21, 22, 25, 26, 27, 28, 29, 30, 31, 32, 34, 35, 36 and 37 are analog switches, components 23, 24, 38 and 39 are capacitors, a component 33 is an amplifier, a component 101a is a differential output voltage, components 107 and 108 are voltages at their respective points, and a component 109 is a common-mode reference voltage. In addition, the capacitors 23 and 24 compose hold capacitors 201, the capacitors 38 and 39 compose hold capacitors 202, the analog switches 19 to 22 and 25 to 28 compose a switch circuit 203, and the analog switches 29 to 32 and 34 to 37 compose a switch circuit 204.

The differential input voltage 100 is connected to one end each of the analog switches 19 and 22, the other end of the analog switch 19 is connected to one end each of the capacitor 23 and the analog switch 25, and the other end of the analog switch 22 is connected to one end each of the capacitor 24 and the analog switch 28. In addition, the common-mode reference voltage 109 is connected to one end each of the analog switches 20, 21, 35 and 36.

The other end of the capacitor 23 is connected to the other end of the analog switch 20 and to one end of the analog switch 26, and the other end of the capacitor 24 is connected to the other end of the analog switch 21 and to one end of the analog switch 27.

The other end of the analog switch 25 is connected to one end each of the analog switches 29 and 34 and to the inverting output terminal of the amplifier 33, and the other end of the analog switch 26 is connected to one end of the analog switch 30 and to the non-inverting input terminal of the amplifier 33.

The other end of the analog switch 28 is connected to one end each of the analog switches 32 and 37 and to the non-inverting output terminal of the amplifier 33, and the other end of the analog switch 27 is connected to one end of the analog switch 31 and to the inverting input terminal of the amplifier 33.

The other end of the capacitor 29 is connected to the other end of the analog switch 37 and to one end of the capacitor 39, and the other end of the analog switch 30 is connected to the other end of the analog switch 36 and the other end of the capacitor 39.

The other end of the analog switch 32 is connected to the other end of the analog switch 34 and to one end of the capacitor 38, and the other end of the analog switch 31 is connected to the other end of the analog switch 35 and the other end of the capacitor 38.

In addition, a control signal 102 is connected to the control input terminal of each of the analog switches 19, 20, 21, 22, 29, 30, 31 and 32, and a control signal 103 is connected to the control input terminal of each of the analog switches 25, 26, 27, 28, 34, 35, 36 and 37. In addition, the non-inverting and inverting output terminals of the amplifier 33 provide the differential output voltage 101a.

Here, the behavior of the embodiment of Figure 5 is explained using Figures 6, 7 and 8. Figure 6 is a timing diagram representing the behavior of the embodiment. Figures 7 and 8 are schematic diagrams showing the connection relationship among the circuit components during each timing phase.

As shown in Figure 6, the control signals 102 and 103 are clock signals having phases that are reverse to each other. During the P101 phase in the figure, the control signal 102 is at a high level and the control signal 103 is at a low level. Hence, in this phase the analog switches 19, 20, 21, 22, 29, 30, 31 and 32 are on and the analog switches 25, 26, 27, 28, 34, 35, 36 and 37 are off.

In other words, all these analog switches can be classified into two groups: a group that is driven by the control signal 102 and a group that is driven by the control signal 103.

During the P101 phase in Figure 6, the connection relationship between the amplifiers 33 and the capacitors 23, 24, 38 and 39, which are circuit components, is as shown in Figure 7. That is, the differential input voltage 100 is applied to one end each of the capacitors 23 and 24 and the common-mode reference voltage 109 is applied to the other end of each of the capacitors 23 and 24, thereby equalizing the voltage 107 that develops across the hold capacitors 201 to the differential input voltage 100.

During the P102 phase in Figure 6, however, the control signal 102 is at a low level and the control signal 103 is at a high level. Hence, in this phase the analog switches 19, 20, 21, 22, 29, 30, 31 and 32 are off and the analog switches 25, 26, 27, 28, 34, 35, 36 and 37 are on.

During the P102 phase in Figure 6, the connection relationship between the amplifiers 33 and the capacitors 23, 24, 38 and 39, which are circuit components, is as shown in Figure 8. In summary, a feedback loop is formed via the capacitors 23 and 24 in the amplifier 33 by means of the switch circuit 203. If the input bias current of the amplifier 33 is zero, the electric charge injected into the capacitors 23 and 24, i.e., the hold capacitors 201, is not discharged. Hence, the capacitors retain the final value of the differential input voltage 100 when the control signal 102 changes to a low-level state and the control signal 103 changes to a high-level state.

The amplifier 33 is isolated by means of the switch circuit 203 when the capacitors 23 and 24 are charged. Hence, assuming the final value of the differential input voltage 100 is Vk1, then the differential voltage Vc3 retained by the capacitors 23 and 24 is$\text{Vc3 = Vk1}$

Then, by assuming the offset voltage of the amplifier 33 is Vos33 and the differential output voltage 101a, which is the output voltage of the amplifier 33, is Vouta, the value of the differential output voltage 101a can be equated as follows:$\text{Vouta = Vc3 + Vos33} \text{= Vk1+ Vos33}$

In other words, the amplifier 33 outputs the final voltage Vk1, superposed with the amplifier's offset voltage Vos33, as the differential output voltage 101a. At the same time, this voltage 101a is applied to one end each of the capacitors 38 and 39, which are the hold capacitors 202, and the common-mode reference voltage 109 is applied to the other end of each of the capacitors 38 and 39.

Consequently, by assuming that the voltage 108 that develops across the hold capacitors 202 is V108, the V108 will equal the voltage shown in equation 5, that is$\text{V108 = Vk1 + Vos33}$

Referring back to Figure 6, if the control signal 102 is at a high level and the control signal 103 is at a low level during the P103 phase, the amplifier 33 reverts to the connection relationship shown in Figure 7. Consequently, a feedback loop is formed via the capacitors 38 and 39 in the amplifier 33 by means of the switch circuit 204. At this point, however, the capacitors 38 and 39 composing the hold capacitors 202 are reconnected to the amplifier 33 with the polarities of the amplifier's terminals in reverse to the previous ones.

More specifically, this is explained as follows:

During the P102 phase in Figure 6, terminal **a** shown in Figure 5, which is one end of the capacitor 38, is connected to the inverting output terminal of the amplifier 33, and terminal **d** in Figure 5, which is one end of the capacitor 39, is connected to the non-inverting output terminal of the amplifier 33, as shown in Figure 8.

During the P103 phase in Figure 6 however, terminal **d** is connected to the inverting output terminal of the amplifier 33 and terminal **a** is connected to the non-inverting output terminal of the amplifier 33, as shown in Figure 7.

Consequently. if the input bias current of the amplifier 33 is zero, the electric charge injected into the capacitors 38 and 39, which are the hold capacitors 202, is not discharged. The differential output voltage 101a during the P103 phase in Figure 6 is therefore represented as$\text{Vouta = -V108 + Vos33} \text{= -(Vk1 + Vos33) + Vos33} \text{= -Vk1}$

This means that during the P101 phase in Figure 6, a voltage, which is reverse in polarity to the final voltage level Vk1 retained by the hold capacitors 201. is output with a delay of one clock each for the control signals 102 and 103. In addition, the offset voltage is corrected at this time.

As a result, it is possible to correct the offset-voltage component of a voltage obtained by reversing the polarity of the voltage retained by the hold capacitors 201, and output the voltage with a delay of one clock. This is achieved by allowing the voltage retained by the hold capacitors 201, by means of the switch circuit 203, to be held by the hold capacitors 202, by means of the switch circuits 203 and 204, and then feeding that voltage back to the amplifier 33 by means of the switch circuit 204 with the voltage's polarity reversed.

In other words, it is possible to correct the offset-voltage component of a voltage obtained by reversing the polarity of the voltage retained by the amplifier 33, and then output the voltage with a delay of one clock. This makes it possible to reduce both the scale of circuit integration and the amount of power consumption to almost half.

Figure 9 is a circuit diagram showing the second embodiment of the switched capacitor amplifier in accordance with the present invention. In Figure 9, the components with reference numbers 19 to 39, 100, 102, 103, 107, 108, 109, 201, 202 and 203 are the same as those in Figure 5. Components 40, 41, 44 and 45 are analog switches, components 42 and 43 are capacitors, and a component 101b is a differential output voltage. In addition, the capacitors 42 and 43 compose hold capacitors 205, and the capacitors 29 to 37, 40, 41, 44 and 45 compose a switch circuit 206.

The differential input voltage 100 is connected to one end each of the analog switches 19 and 22, the other end of the analog switch 19 is connected to one end each of the capacitor 23 and the analog switch 25, and the other end of the analog switch 22 is connected to one end each of the capacitor 24 and the analog switch 28. In addition, the common-mode reference voltage 109 is connected to one end each of the analog switches 20, 21, 35, 36, 44 and 45.

The other end of the capacitor 23 is connected to the other end of the analog switch 20 and to one end of the analog switch 26, and the other end of the capacitor 24 is connected to the other end of the analog switch 21 and to one end of the analog switch 27.

The other end of the analog switch 25 is connected to one end each of the analog switches 29, 34 and 40 and to the inverting output terminal of the amplifier 33. The other end of the analog switch 26 is connected to one end of the analog switch 30 and to the non-inverting input terminal of the amplifier 33.

The other end of the analog switch 28 is connected to one end each of the analog switches 32, 37 and 41 and to the non-inverting output terminal of the amplifier 33. The other end of the analog switch 27 is connected to one end of the analog switch 31 and to the inverting input terminal of the amplifier 33.

The other end of the analog switch 29 is connected to the other end of the analog switch 37 and to one end of the capacitor 39, and the other end of the analog switch 30 is connected to the other end of the analog switch 36, the other end of the capacitor 39 and one end of the capacitor 43.

The other end of the capacitor 43 is connected to the other end of each of the analog switches 41 and 45.

The other end of the capacitor 32 is connected to the other end of the analog switch 34 and to one end of the capacitor 38, and the other end of the analog switch 31 is connected to the other end of the analog switch 35, the other end of the capacitor 38 and one end of the capacitor 42.

The other end of the capacitor 42 is connected to the other end of each of the analog switches 40 and 44.

In addition, a control signal 102 is connected to the control input terminal of each of the analog switches 19, 20, 21, 22, 29, 30, 31, 32, 44 and 45, and a control signal 103 is connected to the control input terminal of each of the analog switches 25, 26, 27, 28, 34, 35, 36, 37, 40 and 41. In addition, the non-inverting and inverting output terminals of the amplifier 33 provide the differential output voltage 101b.

The behavior of the embodiment of Figure 9 is now explained using Figures 10 and 11. Figures 10 and 11 are schematic diagrams showing the connection relationship among the circuit components during each timing phase. Any information that is the same as that covered in Figure 5, is not explained again, however.

If the control signal 102 is at a high level and the control signal 103 is at a low level, the analog switches 19, 20, 21, 22, 29, 30, 31, 32, 44 and 45 are on and the analog switches 25, 26, 27, 28, 34, 35, 36, 37, 40 and 41 are off.

In this timing phase, the connection relationship between the amplifier 33 and the capacitors 23, 24, 38, 39, 42 and 43, which are circuit components, is as shown in Figure 10. In addition, like the embodiment of Figure 5, the differential input voltage 100 is applied to one end each of the capacitors 23 and 24 by means of the switch circuit 203, and the common-mode reference voltage 109 is applied to the other end of each of the capacitors 23 and 24, thereby equalizing the voltage 107 that develops across the hold capacitors 201 to the differential input voltage 100.

However, if the control signal 102 is at a low level and the control signal 103 is at a high level, the analog switches 19, 20, 21, 22, 29, 30, 31, 32, 44 and 45 are off and the analog switches 25, 26, 27, 28, 34, 35, 36, 37, 40 and 41 are on.

In this timing phase, the connection relationship between the amplifier 33 and the capacitors 23, 24, 38, 39, 42 and 43, which are circuit components, is as shown in Figure 11. In addition, like the embodiment of Figure 5, the amplifier 33 outputs the final voltage Vk1, superposed with the amplifier's offset voltage Vos33, as the differential output voltage 101b.

At the same time, this voltage 101b is applied to one end each of the capacitors 38 and 39, which are the hold capacitors 202, and to one end each of the capacitors 42 and 43, which are the hold capacitors 205, by means of the switch circuit 206. The common-mode reference voltage 109 is applied to the other end of each of the capacitors 38 and 39 and to the other end of each of the capacitors 42 and 43. Consequently, assuming the voltage 108 that develops across both the hold capacitors 202 and the hold capacitors 205 is V108, then the V108 equals the voltage shown in equation 5. When the control signals 102 and 103 change back to high and low levels respectively, the connection relationship reverts to the one shown in Figure 10. At this point, however, the common-mode reference voltage 109 is applied to one end each of the capacitors 42 and 43 and the other end of each of these capacitors serves as an artificial ground. As a result, charge transfer takes place in the direction from the capacitors 42 and 43 to the capacitors 38 and 39.

This process is explained using Figures 12 and 13. Figures 12 and 13 are schematic diagrams showing voltages at the respective circuit components before and after charge transfer. For ease of explanation, the common-mode reference voltage 109 is assumed to be 0 V.

In addition, the capacitance of the capacitors 38 and 39 is assumed to be C and the capacitance of the capacitors 42 and 43 to be n*C.

In the state before charge transfer shown in Figure 12, the voltage level $\text{Vk1 + Vos33}$ shown in equation 5 is retained by the capacitors 38 and 39 and by the capacitors 42 and 43, as illustrated in Figure 11. Since, in this case, the common-mode reference voltage 109 is assumed to be 0 V, each of the capacitors 38, 39, 42 and 43 retains the voltage level $\text{(Vk1 + Vos33)/2}$.

If in this state, the connection relationship is as shown in Figure 13, the voltage level at one end each of the capacitors 42 and 43 becomes 0 V and the offset voltage Vos33 of the amplifier 33 is applied to the other ends of the capacitors 42 and 43. As a result, the electric charge is released from each of the capacitors 42 and 43 and the voltage level retained by these capacitors changes to Vos33/2.

This means that if we assume that the electric charge transferred from each of the capacitors 42 and 43 is Q, then the following equation holds true.$\text{Q = n*C*{(Vk1 + Vos33)/2 - Vos33/2}} \text{= n*C*Vk1/2}$

Since this charge is injected into each of the capacitors 38 and 39, then following equation also holds true given that the voltages that develop across the capacitors 38 and 39 are V38 and V39, respectively.$\text{V38 = -V39} \text{= (Vk1 + Vos33)/2 + Q/C} \text{= (Vk1 + Vos33)/2 + n*Vk1/2} \text{= {(1 + n)*Vk1 + Vos33}/2}$

Hence, assuming the differential output voltage 101b, which is the amplifier 33's output, is Voutb, then:$\text{Voutb = V38 = V39 + Vos33} \text{= 2*{(1 + n)*Vk1 + Vos33}/2 + Vos33} \text{= -(1 + n)*Vk1}$

From equation 10, it is understood that a voltage, which is reverse in polarity to the final voltage Vk1 retained by the hold capacitors 201 and is (n + 1) times higher than the voltage Vk1, is output with a delay of one clock each for the control signals 102 and 103. In addition, the offset-voltage component of the output voltage is corrected at this time.

As a result, it is possible to correct the offset-voltage component of the voltage obtained by reversing the polarity of the voltage retained by the hold capacitors 201 and amplifying it; and to output the voltage with a delay of one clock, by allowing the voltage retained by the hold capacitors 201 by means of the switch circuit 203, to be held by the hold capacitors 202 and 205 by means of the switch circuits 203 and 206; transferring the electric charge in the hold capacitors 205 to the hold capacitors 202; and then feeding the voltage retained by the hold capacitors 202 back to the amplifier 33 by means of the switch circuit 206, with the voltage polarity reversed.

Figure 14 is a circuit diagram showing the third embodiment of the switched capacitor amplifier in accordance with the present invention. This switched capacitor amplifier can prevent the polarity of the voltage retained by the hold capacitors 201 from being reversed.

In Figure 14, the components with reference numbers 19 to 33, 35, 36, 38, 39, 100, 102, 103, 107, 108, 109, 201, 202 and 204 are the same as those in Figure 5. Components 46 and 47 are analog switches and a component 101c is a differential output voltage. In addition, components 19 to 22, 25 to 28, 46 and 47 compose a switch circuit 207.

The connection relationship is basically the same as the one shown in Figure 5, except that the inverting output terminal of the amplifier 33 is connected to one end each of the analog switches 29 and 46, the amplifier's non-inverting output terminal is connected to one end each of the analog switches 32 and 47, and the other end of each of the analog switches 46 and 47 is connected to the other end of each of the analog switches 25 and 28 - and so on.

Here, the behavior of the embodiment of Figure 14 is explained using Figures 15 and 16. Figures 15 and 16 are schematic diagrams showing the connection relationship among the circuit components during each timing phase. Any information that is the same as that covered in Figure 5, is not explained again, however.

The circuit diagrams shown in Figures 15 and 16 are virtually the same as those in Figures 7 and 8 in terms of the connection relationship among the circuit components. However, since this embodiment is configured so that during the timing phase in Figure 15, the voltage across one end each of the capacitors 38 and 39, which are both ends of the hold capacitors 202, serves as the differential output voltage 101c, a voltage having the same polarity as the final voltage Vk1 is output across the hold capacitors 201 with a delay of one clock each for the control signals 102 and 103. In addition, the offset-voltage component of the output voltage is corrected during this time also.

As a result, it is possible to correct the offset-voltage component of the voltage obtained by keeping the voltage retained by the hold capacitors 201 in the same polarity; and to output the voltage with a delay of one clock, by allowing the voltage retained by the hold capacitors 201 by means of the switch circuit 207, to be held by the hold capacitors 202 by means of the switch circuits 204 and 207, and feeding the voltage retained by the hold capacitors 202 back to the amplifier 33 by means of the switch circuit 204, with the voltage's polarity reversed, and then setting the voltage that develops across the hold capacitors 202 as the differential output voltage.

Figure 17 is a circuit diagram showing the fourth embodiment of the switched capacitor amplifier in accordance with the present invention. This switched capacitor amplifier can amplify the voltage retained by the hold capacitors 201 and prevent the voltage's polarity from being reversed.

In Figure 17, the components with reference numbers 20 to 24, 26, 27, 29 to 33, 35, 36, 38, 39, 100, 102, 103, 107, 108, 109, 201 and 202 are the same as those in Figure 5, and the components with reference numbers 42, 43 and 205 are the same as those in Figure 9. Components 48 to 61 are analog switches, a component 101d is a differential output voltage, and a component 110 is an external input voltage, such as an output from a D/A converter.

In addition, components 20, 21, 26, 27, 48, 49, 52, 53, 54 and 55 compose a switch circuit 208 and components 29 to 32, 50, 51, and 56 to 61 compose a switch circuit 209.

The differential input voltage 100 is connected to one end each of the analog switches 48 and 49, the other end of the analog switch 48 is connected to one end of the capacitor 23 and to one end each of the analog switches 50 and 51, the other end of the analog switch 49 is connected to one end of the capacitor 24 and to one end each of the analog switches 56 and 57. In addition, the common-mode reference voltage 109 is connected to one end each of the analog switches 20, 21, 35 and 36.

The other end of the capacitor 23 is connected to the other end of the analog switch 20 and to one end of the analog switch 26, and the other end of the capacitor 24 is connected to the other end of the analog switch 21 and to one end of the analog switch 27. The other end of the analog switch 26 is connected to one end each of the analog switch 30 and to the non-inverting input terminal of the amplifier 33, while the other end of the analog switch 27 is connected to one end of the analog switch 31 and to the inverting input terminal of the amplifier 33.

The inverting output terminal of the amplifier 33 is connected to one end each of the analog switches 29, 52 and 53, and the amplifier's non-inverting output terminal is connected to one end each of the analog switches 32, 54 and 55.

The other end of the analog switch 29 is connected to one end of the analog switch 61, and the other end of the analog switch 30 is connected to one end of the analog switch 36 and to one end each of the capacitors 39 and 43. The other end of the capacitor 43 is connected to the other end of each of the analog switches 54 and 56 and to one end of the analog switch 59.

The other end of the analog switch 32 is connected to one end of the analog switch 60, and the other end of the analog switch 31 is connected to the other end of the analog switch 35 and to one end each of the capacitors 38 and 42.

The other end of the capacitor 42 is connected to the other end of each of the analog switches 51 and 53 and to one end of the analog switch 58.

The other end of the capacitor 38 is connected to the other end of each of the analog switches 50, 52 and 60, and the other end of the capacitor 39 is connected to the other end of each of the analog switches 55, 57 and 61.

In addition, a control signal 102 is connected to the control input terminal of each of the analog switches 20, 21, 29, 30, 31, 32, 48, 49, 58, 59, 60 and 61, and a control signal 103 is connected to the control input terminal of each of the analog switches 26, 27, 35, 36 and 50 to 57. In addition, an external input voltage 110, such as an output from a D/A converter, is connected to the other end of each of the analog switches 58 and 59, and the analog switches 60 and 61 provide the differential output voltage 101d across each of these ends.

The behavior of the embodiment of Figure 17 is now explained using Figures 18 and 19. Figures 18 and 19 are schematic diagrams showing the connection relationship among the circuit components during each timing phase. Any information that is the same as that covered in Figure 5, is not explained again, however.

The connection relationships among basic circuit components in Figures 18 and 19 are the same as the ones shown in Figures 10 and 11, except that the external input voltage 110, such as an output from a D/A converter, rather than the common-mode reference voltage 109, is connected to one end each of the capacitors 42 and 43.

Another difference is that this embodiment is configured so that during the timing phase in Figure 18, the switched capacitor amplifier outputs the voltage that develops across the hold capacitors 202, through the analog switches 60 and 61, as the differential output voltage 101d.

For example, assuming the external input voltage 110, such as an output from a D/A converter, is 0 V, and, as discussed earlier, the capacitance of the capacitors 38 and 39 is C and the capacitance of the capacitors 42 and 43 is n*C (n is an integer), then a voltage, which has the same polarity as the final voltage Vk1 retained by the hold capacitors 201 during the timing phase in Figure 18 and is (n + 1) times higher than the voltage Vk1, is output across the hold capacitors 201 with a delay of one clock each for the control signals 102 and 103. In addition, the offset voltage-output component of the voltage is corrected at this time.

As a result, it is possible to correct the offset-voltage component of the voltage obtained by keeping the voltage retained by the hold capacitors 201 in the same polarity and amplifying it; and to output the voltage with a delay of one clock, by allowing the voltage retained by the hold capacitors 201 to be held by the hold capacitors 202 and 205 by means of the switch circuits 208 and 209, then transferring the electric charge in the hold capacitors 205 to the hold capacitors 202 and feeding the voltage retained by the hold capacitors 202 back to the amplifier 33 by means of the switch circuit 209 with the voltage's polarity reversed, and finally setting the voltage that develops across the hold capacitors 202 as the differential output voltage.

Furthermore, it is possible to add an extra voltage level to the differential output voltage 101d by setting the external input voltage 110 appropriately.

Figure 20 is a block diagram showing one example of how the switched capacitor amplifier shown in Figure 17 is applied to a high-speed pipeline A/D converter. In Figure 20, components 62a, 62b, 62c and 62d are one-bit pipeline stage circuits (hereinafter simply referred to as stage circuits), a component 63 is a one-bit A/D converter, a component 64 is a sample-and-hold circuit, a component 65 is a subtracter, a component 66 is a one-bit A/D converter, a component 67 is a latch, a component 68 is a one-bit D/A converter, a component 69 is a residue amplifier, a component 111 is an analog input, and a component 112 is an A/D-converted output.

This section will now explain the example of when the switched capacitor amplifier is applied to a high-speed pipeline A/D converter as shown in Figure 20. The analog input 111 is applied to the stage circuit 62a, whose analog output is connected to the stage circuit 62b. In addition, the analog output of the stage circuit 62b is connected to the stage circuit 62c, whose analog output is connected to the stage circuit 62d.

Furthermore, the analog output of the stage circuit 62d is connected to the one-bit A/D converter 63, while the digital outputs of the stage circuits 62a, 62b, 62c and 62d and the digital output of the one-bit A/D converter 63 are provided as the A/D-converted output 112.

As illustrated in detail in Figure 20, each stage circuit is configured so that the analog input 111 or the analog output of a preceding stage circuit is connected to a sample-and-hold circuit 64 and a one-bit A/D converter 66, and the analog output of the sample-and-hold circuit 64 is connected to the adding input terminal of the subtracter 65.

Meanwhile, the digital output of the one-bit A/D converter 66 is connected through the latch 67 to the one-bit D/A converter 68, whose output is connected to the subtracting input terminal of the subtracter 65. In addition, the output of the subtracter is connected through the residue amplifier 69 with a gain of two to the subsequent stage circuit.

By converting the analog input 111 using the one-bit A/D converter 66 to digital signals, one bit at a time, as noted earlier; doubling the difference between the analog input and the analog signal which is obtained by re-converting each of these digital signals with the one-bit D/A converter 68; and then outputting the obtained analog signal to each subsequent stage in succession; it is possible to obtain digital signals having the resolution as high as the number of stage circuits used.

At this point, it is understood that the switched capacitor amplifier shown in Figure 17 is configured to include the sample-and-hold circuit 64, the subtracter 65, and the residue amplifier 69 shown in Figure 20.

For example, in the connection relationship shown in Figure 18, the differential input voltage 100 is retained by the hold capacitors 201. In the connection relationship shown in Figure 19, the voltage 100 retained by the hold capacitors 201 is held by the hold capacitors 202. In the next timing phase, the voltage retained by the hold capacitors 202 is output with its offset-voltage component corrected. This means that the functionality of the sample-and-hold circuit 64 can be achieved.

Similarly, it is possible to obtain a gain of 2 in the connection relationship shown in Figure 18, for example, by setting the capacitors 38, 39, 42 and 43 in Figure 17 to the same value of capacitance and thereby defining the parameter n as "n = 1."

Furthermore, since the external input voltage 110, such as an output from a D/A converter, is applied to one end each of the capacitors 42 and 43, not only the electric charge in the capacitors 42 and 43 is transferred to the capacitors 38 and 39 but also an electric charge based on the external input voltage 110 is added to that electric charge. Consequently, by appropriately setting the external input voltage 110, it is possible to achieve the functionality of the subtracter 65 and the residue amplifier 69. Note that the application shown in Figure 20 is one example only and it is easy for persons skilled in the art to apply each of the embodiments shown in Figures 5, 9, 14 and 17 to various purposes.

According to the configurations of the present invention, it is possible to correct the offset-voltage component of the voltage obtained by reversing the polarity of the voltage retained by the first hold capacitors; and to output the voltage with a delay of one clock, by allowing the voltage retained by the first hold capacitors by means of the first switch circuit to be held by the second hold capacitors by means of the first and second switch circuits, and then feeding the voltage retained by the second hold capacitors back to the amplifier 33 by means of the second switch circuit, with the voltage's polarity reversed. In other words, it is possible to correct the offset-voltage component of a voltage obtained by reversing the polarity of a given retained voltage and to output the voltage with a delay of one clock, using just one amplifier.

Consequently, both the scale of circuit integration and the power consumption of conventional switched capacitor amplifiers can be reduced to as little as half their previous values.

In addition, by setting the voltage retained by the second hold capacitors as the differential output voltage, it is possible to correct the offset-voltage component of the voltage obtained by keeping the voltage retained by the first hold capacitors in the same polarity; and to output the voltage with a delay of one clock. It is also possible to deal with differential signals by setting the input/output voltages as differential voltages.

Furthermore, it is possible to correct the offset-voltage component of the voltage obtained by reversing the polarity of the voltage retained by the first hold capacitors and amplifying it; and to output the voltage with a delay of one clock, by allowing the voltage retained by the first hold capacitors by means of the first switch circuit to be held by the second and third hold capacitors by means of the first and second switch circuits, and then transferring the electric charge in the third hold capacitors to the second hold capacitors and feeding the voltage retained by the second hold capacitors back to the amplifier 33 by means of the second switch circuit, with the voltage's polarity reversed.

Furthermore, it is possible to correct the offset-voltage component of the voltage obtained by keeping the voltage retained by the first hold capacitors in the same polarity and amplifying it; and to output the voltage with a delay of one clock, by allowing the voltage retained by the first hold capacitors by means of the first switch circuit, to be held by the second and third hold capacitors by means of the first and second switch circuits, and then transferring the electric charge in the third hold capacitors, to which an external input voltage is added, to the second hold capacitors, and feeding the voltage retained by the second hold capacitors back to the amplifier 33 by means of the second switch circuit, with the voltage's polarity reversed, and finally setting the voltage that develops across the second hold capacitors as the differential output voltage. It is also possible to add an extra voltage to the differential output voltage by appropriately setting the external input voltage. It is also possible to deal with differential signals by setting the input/output voltages as differential voltages.

Furthermore, the switched capacitor amplifier of the present invention can be used in place of the sample-and-hold circuit, the subtracter and the residue amplifier at each of the one-bit pipeline stages that compose a high-speed pipeline A/D converter, in order to apply the switched capacitor amplifier to high-speed pipeline A/D converters.

## Claims

1. A switched capacitor amplifier comprising:
first hold capacitors;
second hold capacitors:
a transconductance amplifier;
a first switch circuit for either allowing said first hold capacitors to retain an input voltage, or for outputting the retained input voltage through said transconductance amplifier; and
a second switch circuit for either feeding a voltage obtained by reversing the polarity of the voltage retained by said second hold capacitors back to said transconductance amplifier for output as the amplifier's output voltage, or for allowing the voltage retained by said first hold capacitors to be held by said second hold capacitors.

2. A switched capacitor amplifier comprising:
first hold capacitors;
second hold capacitors;
a transconductance amplifier;
a first switch circuit for either allowing said first hold capacitors to retain an input voltage, or for outputting the retained input voltage through said transconductance amplifier; and
a second switch circuit for either feeding a voltage obtained by reversing the polarity of the voltage retained by said second hold capacitors back to said transconductance amplifier for output, or for allowing the voltage retained by said first hold capacitors to be held by said second hold capacitors, wherein the voltage across said second hold capacitors is provided as an output voltage.

3. A switched capacitor amplifier comprising:
first hold capacitors;
second hold capacitors;
third hold capacitors;
a transconductance amplifier;
a first switch circuit for either allowing said first hold capacitors to retain an input voltage or for outputting the retained input voltage through said transconductance amplifier; and
a second switch circuit for either transferring the electric charge in said third hold capacitors to said second hold capacitors and feeding a voltage obtained by reversing the polarity of the voltage retained by said second hold capacitors back to said transconductance amplifier for output as the amplifier's output voltage, or for allowing the voltage retained by said first hold capacitors to be held by said second and third hold capacitors.

4. A switched capacitor amplifier comprising:
first hold capacitors;
second hold capacitors;
third hold capacitors;
a transconductance amplifier;
a first switch circuit for either allowing said first hold capacitors to retain an input voltage, or for outputting the retained input voltage through said transconductance amplifier; and
a second switch circuit for either transferring the electric charge in said third hold capacitors, to which an external input voltage is applied, to said second hold capacitors and feeding a voltage obtained by reversing the polarity of the voltage retained by said second hold capacitors back to said transconductance amplifier for output, or for allowing the voltage retained by said first hold capacitors to be held by said second and third hold capacitors, wherein the voltage across said second hold capacitors is provided as an output voltage.

5. A switched capacitor amplifier as defined in claim 1, 2, 3 or 4, wherein said first switch circuit comprises:
a first group of analog switches that apply said input voltage to said first hold capacitors; and
a second group of analog switches that form a feedback loop via said first hold capacitors in said transconductance amplifier.

6. A switched capacitor amplifier as defined in claim 1 or 2, wherein said second switch circuit comprises:
a first group of analog switches that form a feedback loop via said second hold capacitors in said transconductance amplifier; and a second group of analog switches that apply the output of said transconductance amplifier to said second hold capacitors.

7. A switched capacitor amplifier as defined in claim 3 or 4, wherein said second switch circuit comprises:
a first group of analog switches that form a loop for transferring the electric charge in said third hold capacitors to said second hold capacitors and form a feedback loop via said second hold capacitors in said transconductance amplifier; and
a second group of analog switches that apply the output voltage of said transconductance amplifier to said second and third hold capacitors.

8. A switched capacitor amplifier as defined in claim 1, 2, 3 or 4, wherein said input voltage and said output voltage are a differential output voltage.

9. A switched capacitor amplifier as defined in claim 8, wherein said first hold capacitors consist of first and second capacitors connected in series and when said differential input voltage is allowed to be retained, a common-mode reference voltage is applied to the connecting point of said first and second capacitors and said differential input voltage is applied to one end each of said first and second capacitors.

10. A switched capacitor amplifier as defined in claim 8, in combination with claim 1 or 2 wherein said second hold capacitors consist of first and second capacitors connected in series and when the voltage retained by said first hold capacitors is allowed to be held by said second hold capacitors, a common-mode reference voltage is applied to the connecting point of said first and second capacitors and said retained voltage is applied to one end each of said first and second capacitors.

11. A switched capacitor amplifier as defined in claim 8 in combination with claim 3 or 4, wherein said second and third hold capacitors consist of first and second capacitors connected in series and third and fourth capacitors also connected in series; and when the voltage retained by said first hold capacitors is allowed to be held by second and third hold capacitors, a common-mode reference voltage is applied to the connecting point of each said first and second capacitors as well as that of each said third and fourth capacitors, and said retained voltage is applied to one end each of said first and second capacitors and also to one end each of said third and fourth capacitors.

12. A switched capacitor amplifier as defined in claim 4 for use as a circuit comprising a sample-and-hold circuit, a subtracter and a residue amplifier contained in a one-bit pipeline stage circuit that composes a high-speed pipeline A/D converter.
